# EUROPÄISCHE PATENTANMELDUNG

(11) **EP 3 575 976 A1**
(43) Veröffentlichungstag der Anmeldung: **04.12.2019**
(21) Anmeldenummer: 18174804.7
(22) Anmeldetag: 29.05.2018
(51) Int. Cl.: G06F 15/173, G05B 17/02, G06F 17/50

(54) **VERFAHREN ZUM BESTIMMEN EINER PHYSIKALISCHEN VERBINDUNGSTOPOLOGIE EINES FÜR DIE STEUERGERÄTENTWICKLUNG EINGERICHTETEN, ECHTZEITFÄHIGEN TESTGERÄTS**

(71) Anmelder: dSPACE digital signal processing and control engineering GmbH, 33102 Paderborn (DE)
(72) Erfinder: Meyer, Björn, 33106 Paderborn (DE)

(57) **Zusammenfassung**

Das Verfahren zum Bestimmen einer physikalischen Verbindungstopologie betrifft ein für die Steuergerätentwicklung eingerichteten, echtzeitfähigen Testgeräts (2), wobei das Testgerät (2) eine Vielzahl von Datenverarbeitungseinheiten (16) aufweist, wobei jede Datenverarbeitungseinheit (16) eine festgelegte Menge an physikalischen Schnittstellen für die Kommunikation zwischen den Datenverarbeitungseinheiten (16) hat, und wobei mit der Vielzahl von Datenverarbeitungseinheiten eine Vielzahl von Simulationsmodellen (18) assoziiert ist, wobei die Vielzahl von Simulationsmodellen (18) mindestens ein Modell eines zu steuernden technischen Systems und/oder mindestens ein Modell einer Steuerung eines technischen Systems und/oder mindestens ein technisches Umgebungsmodell umfasst. Das Verfahren weist die folgenden Schritte auf: Bestimmen der logischen Kommunikationsverbindungen (20) zwischen den Simulationsmodellen, wobei jede logische Kommunikationsverbindung eine Datenverbindung zwischen zwei der Vielzahl von Simulationsmodellen repräsentiert und wobei die festgelegte Menge an physikalischen Schnittstellen für mindestens eine der Vielzahl von Datenverarbeitungseinheiten kleiner als die Menge der mit derjenigen Datenverarbeitungseinheit assoziierten logischen Kommunikationsverbindungen ist; und automatisiertes Bestimmen der physikalischen Verbindungstopologie durch Festlegen von direkten physikalischen Kommunikationsverbindungen (24) zwischen den Datenverarbeitungseinheiten unter Berücksichtigung der jeweiligen Mengen an physikalischen Schnittstellen, wobei das Festlegen der direkten physikalischen Kommunikationsverbindungen (24) für jede der logischen Kommunikationsverbindungen (20) festlegt, ob eine der logischen Kommunikationsverbindung (20) entsprechende direkte physikalische Kommunikationsverbindung (24) Teil der physikalischen Verbindungstopologie ist.

## Beschreibung

Die vorliegende Erfindung betrifft die Entwicklung von Steuergeräten, wie sie z.B. in der Automobilindustrie oder in der Luftfahrtindustrie zur Steuerung von technischen Systemen, wie z.B. Motoren oder Bremsen, verwendet werden. Insbesondere betrifft die vorliegende Erfindung Testgeräte, die im Entwicklungsprozess des Steuergeräts verwendet werden, sowie Verfahren zum Einrichten von solchen Testgeräten für das Durchführen von Simulationen für die Steuergerätentwicklung.

Die Entwicklung von Steuergeräten ist zu einem hochkomplexen Prozess geworden. So sollen neue Steuergeräte bzw. neue Steuerfunktionen so früh wie möglich im Entwicklungsprozess getestet werden, um die generelle Funktionalität zu überprüfen und die weitere Entwicklungsrichtung vorzugeben. Gegen Ende des Entwicklungsprozesses ist es wichtig, das schon weit entwickelte Steuergerät möglichst umfassend zu testen, um aufgrund der Testergebnisse notwendige Modifikationen vorzunehmen, bevor das Steuergerät in Benutzung bzw. in Serienfertigung geht, so dass es im späteren Betrieb unter möglichst allen Umständen wie gewünscht arbeitet.

Zu einem recht späten Stadium des Entwicklungsprozesses kommen sogenannte Hardware-in-the-Loop-Simulatoren (HIL-Simulatoren / HIL-Simulationsvorrichtungen) zum Einsatz. Solche HIL-Simulatoren enthalten ein Modell des zu steuernden technischen Systems, wobei das Modell in Software vorliegt. Zusätzlich kann der HIL-Simulator weitere Modelle von technischen Systemen, die sich in der Umgebung des Steuergeräts und des zu steuernden technischen Systems befinden und mit dem Steuergerät und/oder dem zu steuernden technischen System zusammenwirken, enthalten. Somit kann der HIL-Simulator im Allgemeinen eine Vielzahl von Simulationsmodellen enthalten. Diese werden oft auf verschiedenen Prozessoren ausgeführt und tauschen Daten untereinander aus. Der HIL-Simulator enthält weiterhin eine Eingabe/Ausgabe-Schnittstelle, an die das schon weit entwickelte, bereits in Hardware gegenständlich vorhandene Steuergerät, auch als gerätemäßige Implementierung des Steuergeräts bezeichnet, angeschlossen werden kann. In verschiedenen Simulationsdurchläufen kann nun die Funktionalität des Steuergeräts getestet werden, wobei die Reaktionen des Modells des zu steuernden technischen Systems auf die Signale des Steuergeräts sowie die Reaktionen des Steuergeräts auf von dem Modell des zu steuernden technischen Systems vorgegebene Ereignisse beobachtet werden können. Gegebenenfalls kann auch das Verhalten weiterer technischer Systeme aus der Umgebung von Steuergerät und zu steuerndem technischen System beobachtet werden. Dabei können sowohl der normale Betrieb als auch Fehler in dem zu steuernden technischen System als auch Fehler in dem Steuergerät als auch Fehler in der Kommunikation zwischen Steuergerät und zu steuerndem System, wie z.B. Kabelbrücke, als auch Fehler in der Stromversorgung, wie z.B. Kurzschlüsse, simuliert werden. Der HIL-Simulator ist ein Beispiel eines für die Steuergerätentwicklung eingerichteten, echtzeitfähigen Testgeräts. Der Begriff Testgerät wird hierin synonym verwendet mit den Begriffen Simulator, Simulationsgerät und Simulationsvorrichtung.

Demgegenüber ist das sogenannte Rapid Control Prototyping (RCP) ein Entwicklungsschritt, der mehr am Anfang des Entwicklungsprozesses steht. Beim RCP kommt das Testgerät auf Seiten des Steuergeräts zum Einsatz. Das Testgerät enthält ein Modell des zu testenden Steuergeräts. Aufgrund des frühen Entwicklungsstadiums ist das Modell des zu testenden Steuergeräts noch recht rudimentär im Vergleich zu dem späteren finalen Steuergerät. Auch ist normalerweise noch keine Hardware-Implementierung des Steuergeräts vorhanden, vielmehr ist das in dem Testgerät vorhandene Modell des zu testenden Steuergeräts ein Software-Modell. Weiterhin kann das Testgerät weitere Modelle enthalten, wie z.B. Modelle von technischen Systemen, mit denen das Steuergerät später neben dem zu steuernden System interagieren soll. So kann in dem Testgerät eine breite Umgebung des Steuergeräts abgebildet sein. Das Testgerät kann über eine Eingabe/Ausgabe-Schnittstelle mit dem zu steuernden technischen System selbst oder mit dem bisher vorhandenen Steuergerät für das zu steuernde technische System verbunden werden. Im ersten Fall besteht eine direkte Verbindung zwischen dem zu testenden Steuergerät, in der Form eines Software-Modells, und dem gegenständlich vorhandenen, zu steuernden technischen System. Im zweiten Fall ist das bisher vorhandene Steuergerät das durch das RCP-Testgerät zu steuernde technische System. Diese Steuerung des bisher vorhandenen Steuergeräts führt zu einer Modifikation der Steuerverfahren des bisher vorhandenen Steuergeräts, wodurch neue Steuer-Funktionalität mittels des von außen angeschlossenen RCP-Steuergeräts getestet werden kann. Diese Anordnung wird auch als Bypassing bezeichnet.

Der Aufwand zur Vorbereitung einer HIL-Simulation ist im Allgemeinen sehr hoch, insbesondere wenn eine Vielzahl von Simulationsmodellen in dem HIL-Simulator zusammenwirkt, welche auf verschiedenen Prozessoren bzw. Datenverarbeitungseinheiten ausgeführt werden. Bei der Vorbereitung der Simulation wird unter anderem die Kommunikation zwischen den Simulationsmodellen konfiguriert. Eine geeignete Konfiguration der Kommunikation zwischen den Simulationsmodellen ist von hoher Wichtigkeit, weil der Datenaustausch zwischen den Simulationsmodellen Rückwirkungen auf die Echtzeitfähigkeit des Testgeräts hat. Auch bei komplexeren RCP-Simulationen kann der Aufwand zur Vorbereitung einer Simulation sehr hoch sein.

Demzufolge wäre es wünschenswert, ein Verfahren bereitzustellen, welches das Konfigurieren der Kommunikation zwischen den Simulationsmodellen erleichtert bzw. verbessert.

Beispielhafte Ausführungsformen der Erfindung umfassen ein Verfahren zum Bestimmen einer physikalischen Verbindungstopologie eines für die Steuergerätentwicklung eingerichteten, echtzeitfähigen Testgeräts, wobei das Testgerät eine Vielzahl von Datenverarbeitungseinheiten aufweist, wobei jede Datenverarbeitungseinheit eine festgelegte Menge an physikalischen Schnittstellen für die Kommunikation zwischen den Datenverarbeitungseinheiten hat, und wobei mit der Vielzahl von Datenverarbeitungseinheiten eine Vielzahl von Simulationsmodellen assoziiert ist, wobei die Vielzahl von Simulationsmodellen mindestens ein Modell eines zu steuernden technischen Systems und/oder mindestens ein Modell einer Steuerung eines technischen Systems und/oder mindestens ein technisches Umgebungsmodell umfasst. Das Verfahren weist die folgenden Schritte auf: Bestimmen der logischen Kommunikationsverbindungen zwischen den Simulationsmodellen, wobei jede logische Kommunikationsverbindung eine Datenverbindung zwischen zwei der Vielzahl von Simulationsmodellen repräsentiert und wobei die festgelegte Menge an physikalischen Schnittstellen für mindestens eine der Vielzahl von Datenverarbeitungseinheiten kleiner als die Menge der mit derjenigen Datenverarbeitungseinheit assoziierten logischen Kommunikationsverbindungen ist; und automatisiertes Bestimmen der physikalischen Verbindungstopologie durch Festlegen von direkten physikalischen Kommunikationsverbindungen zwischen den Datenverarbeitungseinheiten unter Berücksichtigung der jeweiligen Mengen an physikalischen Schnittstellen, wobei das Festlegen der direkten physikalischen Kommunikationsverbindungen für jede der logischen Kommunikationsverbindungen festlegt, ob eine der logischen Kommunikationsverbindung entsprechende direkte physikalische Kommunikationsverbindung Teil der physikalischen Verbindungstopologie ist.

Beispielhafte Ausführungsformen der Erfindung ermöglichen ein gezieltes automatisiertes Bestimmen der physikalischen Verbindungstopologie auf Basis der für die Simulation erforderlichen logischen Kommunikationsverbindungen zwischen den Simulationsmodellen. Im Gegensatz zu früheren Ansätzen, bei denen die Datenverarbeitungseinheiten ohne Bezug zu den logischen Kommunikationsverbindungen physikalisch verbunden worden sind, z.B. mittels einer regulären Verbindungstopologie, wie z.B. einer Ringtopologie, oder mittels einer zufälligen Verbindungstopologie, kann das Verfahren verbesserte Datenübertragungseigenschaften bereitstellen, weil gezielt zu logischen Kommunikationsverbindungen direkte physikalische Kommunikationsverbindungen bestimmt werden. Im Vergleich zu anderen früheren Ansätzen, bei denen die physikalischen Verbindungen von Hand mit mehr oder weniger Expertenwissen über die verwendeten Simulationsmodelle festgelegt worden sind, ermöglicht das Verfahren auf automatisierte Weise ein zielgerichtetes Abstimmen der physikalischen Verbindungstopologie auf die logischen Kommunikationsverbindungen zwischen den Simulationsmodellen. Für die jeweiligen Mengen an physikalischen Schnittstellen, die für die einzelnen Datenverarbeitungseinheiten zur Verfügung stehen, können die physikalischen Kommunikationsverbindungen automatisiert, effizient und zielgerichtet auf die logischen Kommunikationsverbindungen abgestimmt werden. Auch kann die physikalische Verbindungstopologie mit dem Verfahren gemäß beispielhaften Ausführungsformen der Erfindung ohne detailliertes Wissen über die Simulationsmodelle erstellt werden. Somit kann auch bei unbekanntem Inhalt der Simulationsmodelle, was aus Geheimhaltungsgründen des Öfteren der Fall sein kann, auf Basis der logischen Kommunikationsverbindungen eine effektive physikalische Kommunikationstopologie bestimmt werden.

Das Testgerät weist eine Vielzahl von Datenverarbeitungseinheiten auf, und eine Vielzahl von Simulationsmodellen sind mit der Vielzahl von Datenverarbeitungseinheiten assoziiert. Mit jeder der Vielzahl von Datenverarbeitungseinheiten können dabei ein oder mehrere Simulationsmodelle assoziiert sein. Es ist auch möglich, dass eine oder mehrere der insgesamt in dem Testgerät vorhandenen Datenverarbeitungseinheiten kein Simulationsmodell hat bzw. haben. Jedes Simulationsmodell ist mit genau einer Datenverarbeitungseinheit assoziiert. Das heißt, jedes Simulationsmodell ist dazu eingerichtet, auf genau dieser einen Datenverarbeitungseinheit ausgeführt zu werden. Die Simulationsmodelle können in einer frühen Phase der Konfiguration der Simulation auf die entsprechenden Datenverarbeitungseinheiten geladen werden. Für das Bestimmen der logischen Kommunikationsverbindungen können die Simulationsmodelle in vergleichsweise abstrakter Form, z.B. in einer höheren Programmiersprache, vorliegen oder sie können in einer auf einer Datenverarbeitungseinheit ausführbaren, d.h. kompilierten, Form vorliegen.

Das Testgerät weist eine Vielzahl von Datenverarbeitungseinheiten auf. Jede Datenverarbeitungseinheit kann einen Prozessor bzw. einen Prozessorkern umfassen. Dabei kann die Datenverarbeitungseinheit neben dem Prozessor/Prozessorkern eine geeignete Peripherie aufweisen. Sie kann z.B. mit Routing-Kapazität zu anderen Datenverarbeitungseinheiten ausgestattet sein. Es ist zum Beispiel möglich, dass die mit einer bestimmen Datenverarbeitungseinheit assoziierten Simulationsmodellen auf dem Prozessor der Datenverarbeitungseinheit berechnet werden, während an die bestimmte Datenverarbeitungseinheit übertragene, aber für eine andere Datenverarbeitungseinheit bestimmte Daten ohne Bearbeitung in dem Prozessor weitergeleitet werden.

Die Vielzahl von Simulationsmodellen sind auf die Vielzahl von Prozessoreinheiten aufgeteilt. Für eine in dem Testgerät stattfindende Simulation sind die Simulationsmodelle auf Datenaustausch untereinander angewiesen bzw. zum Datenaustausch untereinander eingerichtet. Für die Gesamtsimulation ist es allerdings in den meisten Fällen nicht nötig bzw. nicht gewünscht, dass jedes der Vielzahl von Simulationsmodellen Daten mit jedem anderen der Simulationsmodelle austauscht. Vielmehr gibt es unter der Vielzahl von Simulationsmodellen eine Vielzahl von Paaren von Simulationsmodellen, die für die Gesamtsimulation Daten austauschen. Diese Paare von Simulationsmodellen bilden die Basis für die logischen Kommunikationsverbindungen.

Das Bestimmen der logischen Kommunikationsverbindungen zwischen den Simulationsmodellen kann beispielsweise durch Analysieren der Simulationsmodelle erfolgen und/oder durch Einlesen der benötigten logischen Kommunikationsverbindungen aus einer entsprechenden Datei oder einem anderen Speichermedium aus einem früheren Verarbeitungsschritt. Das Bestimmen der logischen Kommunikationsverbindungen kann als Ergebnis eine Auflistung von Paaren von Simulationsmodellen haben, die jeweils in der Simulation Daten austauschen sollen.

Jede logische Kommunikationsverbindung repräsentiert eine Datenverbindung zwischen zwei der Vielzahl von Simulationsmodellen. Der Begriff Datenverbindung bezieht sich dabei auf eine für eine gegebene Simulation benötigte bzw. gewünschte Datenverbindung, d.h. auf einen für eine gegebene Simulation benötigten bzw. gewünschten Datenaustauschpfad. Der Datenaustausch kann dabei unilateral oder bilateral sein.

Die festgelegte Menge an physikalischen Schnittstellen kann die für die Kommunikation der Datenverarbeitungseinheiten untereinander vorhandene Menge an physikalischen Schnittstellen sein. Das heißt, die festgelegte Menge an physikalischen Schnittstellen kann die Gesamtmenge der physikalischen Schnittstellen der Datenverarbeitungseinheiten, abzüglich der für andere Zwecke verwendeten physikalischen Schnittstellen, wie z.B. der für die Kommunikation mit der Eingabe/Ausgabe-Schnittstelle des Testgerätes verwendeten physikalischen Schnittstellen, sein. Es ist auch möglich, dass die festgelegte Menge an physikalischen Schnittstellen die Gesamtanzahl der physikalischen Schnittstellen der jeweiligen Datenverarbeitungseinheit ist, wobei auch die logischen Kommunikationsverbindungen nach außerhalb des Testgeräts über die Eingabe/Ausgabe-Schnittstelle des Testgeräts im Verfahrensablauf berücksichtigt werden.

Das automatisierte Bestimmen der physikalischen Verbindungstopologie erfolgt durch Festlegen von direkten physikalischen Kommunikationsverbindungen zwischen den Datenverarbeitungseinheiten unter Berücksichtigung der jeweiligen Mengen an physikalischen Schnittstellen. Dabei wird für jede der logischen Kommunikationsverbindungen festgelegt, ob eine entsprechende direkte physikalische Kommunikationsverbindung Teil der physikalischen Verbindungstopologie ist. Das automatisierte Bestimmen kann dabei weiteren Nebenbedingungen genügen. Zum Beispiel kann die physikalische Verbindungstopologie dergestalt sein, dass es für alle logischen Kommunikationsverbindungen zumindest indirekte physikalische Kommunikationsverbindungen gibt. In anderen Worten, Simulationsmodelle, die eine logische Kommunikationsverbindung miteinander haben, können nicht Teil unterschiedlicher Inseln von verbundenen Simulationsmodellen sein. Weiterhin ist es sowohl möglich, dass direkte physikalische Kommunikationsverbindungen nur dann bestimmt werden können, wenn es eine entsprechende logische Kommunikationsverbindung gibt, als auch möglich, dass direkte physikalische Kommunikationsverbindungen festgelegt werden, für die es keine entsprechenden logischen Kommunikationsverbindungen gibt. Wichtig ist, dass für jede der logischen Kommunikationsverbindungen festgelegt wird, ob die logische Kommunikationsverbindung in der physikalischen Verbindungstopologie im Rahmen einer direkten physikalischen Kommunikationsverbindung oder einer indirekten physikalischen Kommunikationsverbindung implementiert wird.

Gemäß einer weiteren Ausführungsform wird das Festlegen der direkten physikalischen Kommunikationsverbindungen auf Basis einer Optimierungsfunktion durchgeführt. Auf diese Weise wird das Festlegen der direkten physikalischen Kommunikationsverbindungen nicht nur zielgerichtet an die logischen Kommunikationsverbindungen angepasst, sondern zielt auf eine möglichst vorteilhafte Nutzung der begrenzten Ressourcen der physikalischen Schnittstellen für die Implementierung der logischen Kommunikationsverbindungen ab. Eine Optimierungsfunktion bietet einen objektivierten Vergleichswert zwischen verschiedenen physikalischen Verbindungstopologien und stellt somit ein Optimierungskriterium dar, auf Basis dessen die begrenzte Ressource der physikalischen Schnittstellen der Datenverarbeitungseinheiten an die physikalischen Kommunikationsverbindungen vergeben werden können. Die Optimierungsfunktion kann eine oder mehrere Komponenten haben, welche gegeneinander gewichtet sein können. Bei Vorliegen mehrerer laut Optimierungsfunktion optimaler physikalischer Verbindungstopologien können die physikalische Verbindungstopologie aus den optimalen Lösungen zufällig ausgewählt werden. Es ist auch möglich, dass weitere Parameter zu einem nachgelagerten Vergleich herangezogen werden, z.B. die unten mit Bezug auf die Optimierungsfunktion an sich diskutierten Parameter.

Gemäß einer weiteren Ausführungsform berücksichtigt die Optimierungsfunktion die Anzahl derjenigen logischen Kommunikationsverbindungen, für die keine direkte physikalische Kommunikationsverbindung Teil der physikalischen Verbindungstopologie ist. Insbesondere kann die Optimierungsfunktion die Minimierung der Anzahl der indirekten physikalischen Kommunikationsverbindungen als Optimierungsziel haben. In anderen Worten, die Optimierungsfunktion kann ausgelegt sein, die indirekten physikalischen Kommunikationsverbindungen zu minimieren. Auf diese Weise werden diejenigen physikalischen Kommunikationsverbindungen minimiert, für die Daten zwischen der Datenquelle und der Datensenke eine oder mehrere zwischengeschaltete Datenverarbeitungseinheiten durchlaufen müssen. Somit ist eine solche Optimierungsfunktion ein gutes Indiz dafür, dass wenige Daten in Datenverarbeitungseinheiten weitergereicht werden müssen, was im Allgemeinen nachteilig für die Übertragungszeiten der Daten der logischen Kommunikationsverbindungen ist und in den weiterreichenden Datenverarbeitungseinheiten Ressourcen bindet. Auch ist eine solche Minimierung der Anzahl der indirekten physikalischen Kommunikationsverbindungen ein Optimierungsziel, das mit vergleichsweise geringer Komplexität erreicht werden kann.

Gemäß einer weiteren Ausführungsform berücksichtigt die Optimierungsfunktion die Anzahl der durchlaufenen Datenverarbeitungseinheiten für diejenigen logischen Kommunikationsverbindungen, für die keine direkte physikalische Kommunikationsverbindungen Teil der physikalischen Verbindungstopologie ist. Insbesondere kann die Optimierungsfunktion die Minimierung der Anzahl der weiterreichenden Datenverarbeitungseinheiten der indirekten physikalischen Kommunikationsverbindungen als Optimierungsziel haben, weiter insbesondere die Minimierung der Anzahl der weiterreichenden Datenverarbeitungseinheiten über die Gesamtheit der indirekten physikalischen Kommunikationsverbindungen. In anderen Worten, die Optimierungsfunktion kann die Minimierung der sogenannten Hops der indirekten physikalischen Verbindungen als Optimierungsziel haben. Eine solche Minimierung der Hops ist ein gutes Indiz, dass die mit Zeitverzögerungen und Belegung von Ressourcen verbundenen Instanzen des Weiterreichens von Daten in Datenverarbeitungseinheiten minimiert werden. Auch eine solche Minimierung der Hops lässt sich mit relativ geringer Komplexität implementieren, weil jeder indirekten physikalischen Verbindung unmittelbar eine entsprechende Anzahl von Hops zugewiesen werden kann.

Gemäß einer weiteren Ausführungsform berücksichtigt die Optimierungsfunktion zumindest eine Hardware-Eigenschaft von mindestens einem von den Datenverarbeitungseinheiten, den physikalischen Schnittstellen der Datenverarbeitungseinheiten und den physikalischen Kommunikationsverbindungen. Das Berücksichtigen der Hardware-Eigenschaften bei dem Austausch von Daten zwischen Simulationsmodellen auf verschiedenen Datenverarbeitungseinheiten ermöglicht eine relativ konkrete Abschätzung, welche indirekten physikalischen Kommunikationsverbindungen wie große negative Auswirkungen auf die Leistungsfähigkeit des Datenaustauschs haben. Die Optimierungsfunktion berücksichtigt an Stelle von oder zusätzlich zu den abstrakten Größen wie Anzahl der indirekten physikalischen Verbindungen oder Anzahl der Hops die konkreten Eigenschaften von direkten und/oder indirekten physikalischen Kommunikationsverbindungen und stimmt somit das Optimierungsziel besser auf die gegenständlich vorhandene Hardware ab.

Gemäß einer weiteren Ausführungsform umfasst die zumindest eine Hardware-Eigenschaft mindestens eine Eigenschaft von Latenz, maximalem Datendurchsatz und Kollisionshandhabung. Die Hardware-Eigenschaften von Latenz und maximalem Datendurchsatz sind insbesondere relevant bei Datenverarbeitungseinheiten, die bei indirekten physikalischen Verbindungen als weiterreichende Einheiten, d.h. als Router, gebraucht werden. Die Latenz und der maximale Datendurchsatz der als Router fungierenden Datenverarbeitungseinheiten können einen großen Einfluss auf die Gesamtübertragungszeit von Daten zwischen der als Datenquelle fungierenden Datenverarbeitungseinheit und der als Datensenke fungierenden Datenverarbeitungseinheit haben. Der Begriff Kollisionshandhabung betrifft das Umgehen der Hardware-Ressource, z.B. einer physikalischen Kommunikationsverbindung, mit dem Fall, dass beide angeschlossenen Datenverarbeitungseinheiten gleichzeitig von der physikalischen Kommunikationsverbindung Gebrauch machen wollen und die Daten auf der Hardware-Ressource kollidieren. Diesbezüglich kann die Hardware-Eigenschaft darin bestehen, dass es Maßnahmen zur Kollisionsvermeidung gibt oder Maßnahmen zur Kollisionserkennung, gepaart mit wiederholten Datensendungen, welche dann eine zusätzliche Verzögerung in den Datenaustausch bringen.

Gemäß einer weiteren Ausführungsform berücksichtigt die Optimierungsfunktion mindestens eine Kommunikationseigenschaft der logischen Kommunikationsverbindungen. Auf diese Weise können die logischen Kommunikationsverbindungen anhand mindestens einer Kommunikationseigenschaft gewichtet werden, so dass für umfassendere und/oder Echtzeit-kritischere logische Kommunikationsverbindungen eine Tendenz hin zu direkten physikalischen Kommunikationsverbindungen in der Optimierungsfunktion vorhanden sein kann. Auf diese Weise kann die physikalische Verbindungstopologie für die Gesamtsimulation weiter verfeinert werden.

Gemäß einer weiteren Ausführungsform umfasst die mindestens eine Kommunikationseigenschaft mindestens eines von Datenübertragungsrichtung, Taktrate von zu übertragenden Daten, Datenmengen und Datenbedarf asynchroner Ereignisse. Die Datenmenge kann für eine gewisse logische Kommunikationsverbindung für eine gewisse Taktrate bzw. für einen gewissen Zeitraum bekannt sein. Es ist auch möglich, dass die Taktrate bekannt ist und die Datenmenge statistisch modelliert wird. Bei asynchronen Ereignissen kann die Häufigkeit bzw. Auftrittswahrscheinlichkeit ebenfalls bekannt sein oder statistisch modelliert sein. Bei der Simulation in der Steuergeräteentwicklung tauschen die zusammengeschalteten Simulationsmodelle oft vordefinierte Datenpakete, d.h. feste Datenmengen, zu fest vorgegebenen Zeitpunkten, d.h. mit fest vorgegebener Taktung, aus. Es ist aber auch möglich, dass anstatt und/oder zusätzlich zu solchen festen Datenpaketen bei Vorliegen bestimmter Ereignisse Daten ausgetauscht werden. Solche Ereignisse werden als asynchrone Ereignisse bezeichnet.

Gemäß einer weiteren Ausführungsform wird mittels der Optimierungsfunktion diejenige physikalische Verbindungstopologie bestimmt, die einen möglichst schnellen und/oder stabilen Datenaustausch der Simulationsmodelle über die Gesamtheit der logischen Kommunikationsverbindungen erlaubt. Insbesondere kann für einen Simulationsschritt oder eine bestimmte Anzahl von Simulationsschritten oder einen ähnlichen Optimierungshorizont diejenige physikalische Verbindungstopologie bestimmt werden, bei der die Gesamtheit aller zu übertragenden Daten am schnellsten übertragen werden oder bei der die Gesamtheit aller Daten mit einer möglichst hohen Wahrscheinlichkeit in einem echtzeitfähigen Zeitrahmen übertragen werden oder bei der ein gewichteter Hybrid aus möglichst schneller Übertragung und möglichst hoher Wahrscheinlichkeit der Erfüllung von Echtzeitanforderungen ermöglicht wird.

Gemäß einer weiteren Ausführungsform werden in dem Testgerät vorhandene Routing-Regeln auf die bestimmte physikalische Verbindungstopologie angewendet, wodurch der Datenfluss der indirekten physikalischen Kommunikationsverbindungen bestimmt wird. Das Ergebnis kann als Kontrollergebnis an den Benutzer ausgegeben werden. Es ist auch möglich, dass das Ergebnis bei mehreren laut Optimierungsfunktion optimalen physikalischen Verbindungstopologien als Entscheidungskriterium für eine der physikalischen Verbindungstopologien herangezogen wird. Die in dem Testgerät vorhandenen Routing-Regeln können vordefinierte Routing-Regeln sein, die das Testgerät generell für den physikalischen Datenaustausch anwendet.

Gemäß einer weiteren Ausführungsform weist das Testgerät mindestens eine externe Eingabe/Ausgabe-Schnittstelle auf, und zwischen der Vielzahl von Datenverarbeitungseinheiten und der mindestens einen externen Eingabe/Ausgabe-Schnittstelle ist ein Eingabe/Ausgabe-Verbindungsnetzwerk vorhanden. Dabei wird für jede Datenverarbeitungseinheit die festgelegte Menge an physikalischen Schnittstellen auf Basis der Gesamtanzahl von physikalischen Schnittstellen der jeweiligen Datenverarbeitungseinheit und des Eingabe/Ausgabe-Verbindungsnetzwerks bestimmt. Insbesondere kann die für die Kommunikation zwischen den Datenverarbeitungseinheiten festgelegte Menge an physikalischen Schnittstellen die Differenz zwischen der Gesamtzahl an physikalischen Schnittstellen und der von dem Eingabe/Ausgabe-Verbindungsnetzwerk belegten physikalischen Schnittstellen der jeweiligen Datenverarbeitungseinheit bestimmt werden. In anderen Worten, eine erste Menge von physikalischen Schnittstellen einer jeden Datenverarbeitungseinheit kann für das Eingabe/Ausgabe-Verbindungsnetzwerk reserviert werden, wobei die Restmenge der physikalischen Schnittstellen die hierin als festgelegte Menge bezeichnete Menge der physikalischen Schnittstellen für die physikalische Verbindungstopologie zwischen den Datenverarbeitungseinheiten ist.

Auf diese Weise kann das Festlegen der direkten physikalischen Kommunikationsverbindungen bzw. das Optimieren der direkten physikalischen Kommunikationsverbindungen als nachgelagerter Schritt zu dem Festlegen des Eingabe/Ausgabe-Verbindungsnetzwerks erfolgen. Das Festlegen der direkten physikalischen Kommunikationsverbindungen zwischen den Datenverarbeitungseinheiten kann somit unabhängig von der Festlegung des Eingabe/Ausgabe-Verbindungsnetzwerks erfolgen. Es ist aber auch möglich, dass Hardware-Eigenschaften des Eingabe/Ausgabe-Verbindungsnetzwerks und/oder Kommunikationseigenschaften des externen Datenaustauschs über die Eingabe/Ausgabe-Schnittstelle in der Optimierung bezüglich des Festlegens der direkten physikalischen Kommunikationsverbindungen zwischen den Datenverarbeitungseinheiten berücksichtigt werden. Insofern kann die Datenbasis für eine möglichst vorteilhafte physikalische Verbindungstopologie erweitert werden. Es ist weiterhin auch möglich, das Eingabe/Ausgabe-Verbindungsnetzwerk nicht als gegeben hinzunehmen, sondern die physikalischen Verbindungen des Eingabe/Ausgabe-Verbindungsnetzwerks als Teil der physikalischen Verbindungstopologie des Testgeräts zusammen mit den direkten physikalischen Kommunikationsverbindungen zwischen den Datenverarbeitungseinheiten festzulegen. So kann die Nutzung der Kommunikations-Ressourcen weiter verbessert werden. Die externe Eingabe/Ausgabe-Schnittstelle kann in der Form sogenannter I/O-Board(s) vorliegen.

Gemäß einer weiteren Ausführungsform ist das Testgerät ein Hardware-in-the-Loop-Simulator (HIL-Simulator) oder ein Rapid-Control-Prototype (RCP).

Gemäß einer weiteren Ausführungsform sind die Vielzahl von Datenverarbeitungseinheiten zwischen 5 und 20 Datenverarbeitungseinheiten, insbesondere zwischen 10 und 15 Datenverarbeitungseinheiten. Bei einer solch hohen Anzahl von Datenverarbeitungseinheiten, die beispielsweise jeweils 3 oder 4 physikalische Schnittstellen haben können, ist es leicht möglich, dass für eine gegebene Simulation die Anzahl der logischen Kommunikationsverbindungen die Anzahl der möglichen direkten physikalischen Kommunikationsverbindungen weit übersteigt.

Gerade in so einem Fall ist das Verfahren gemäß den hierin dargestellten Ausführungsformen besonders geeignet, eine echtzeitfähige physikalische Verbindungstopologie auf effiziente Weise zu bestimmen.

Gemäß einer weiteren Ausführungsform weist das Verfahren weiterhin den folgenden Schritt auf: Beurteilen der Echtzeitfähigkeit des Testgeräts für die bestimmte physikalische Verbindungstopologie. Insbesondere kann das Beurteilen der Echtzeitfähigkeit des Testgeräts für die bestimmte physikalische Verbindungstopologie unter der Annahme einer gegebenen Simulation stattfinden, insbesondere unter der Annahme von gegebenen Kommunikationsanforderungen der Vielzahl von Simulationsmodellen. Durch das automatisierte Beurteilen der Echtzeitfähigkeit nach dem automatisierten Bestimmen der physikalischen Verbindungstopologie kann dem Benutzer in integrierter und hoch effizienter Weise mitgeteilt werden, ob eine gewünschte Simulation echtzeitfähig durchgeführt werden kann. Bei Bedarf kann der Benutzer schnell durch Ändern der Simulation zu einer echtzeitfähigen Simulation gelangen.

Gemäß einer weiteren Ausführungsform weist das Verfahren weiterhin den folgenden Schritt auf: Ausgeben der physikalischen Verbindungstopologie an einen Benutzer, insbesondere graphisches Ausgeben der physikalischen Verbindungstopologie an einen Benutzer, zur manuellen Erstellung der direkten physikalischen Kommunikationsverbindungen. Das Ausgeben der physikalischen Verbindungstopologie kann das Anzeigen einer Liste der direkten physikalischen Verbindungen oder das Anzeigen der physikalischen Verbindungstopologie als Graph beinhalten. Das manuelle Erstellen der direkten physikalischen Kommunikationsverbindungen kann das manuelle Stecken der entsprechenden Verbindungsleitungen umfassen. Auf diese Weise kann der Benutzer das Ergebnis des automatisierten Bestimmens der physikalischen Verbindungstopologie beim Implementieren dieser physikalischen Verbindungstopologie kontrollieren und gegebenenfalls überstimmen.

Gemäß einer weiteren Ausführungsform weist das Verfahren weiterhin den folgenden Schritt auf: automatisiertes Erstellen von festgelegten direkten physikalischen Kommunikationsverbindungen. Auf diese Weise kann das Ergebnis des automatisierten Bestimmens der physikalischen Verbindungstopologie direkt und ohne Benutzerinteraktion umgesetzt werden, und die Simulation kann mit der bestimmten physikalischen Verbindungstopologie unmittelbar begonnen werden. Das Testgerät kann dynamisch an die Simulation angepasst werden, und es kann eine verbesserte Auslastung des Testgeräts erreicht werden. Das automatisierte Erstellen kann insbesondere ein automatisiertes Erstellen von festgelegten direkten physikalischen Kommunikationsverbindungen mittels Schalten von optischen Schaltern sein. Das automatisierte Erstellen von festgelegten direkten physikalischen Kommunikationsverbindungen kann alle oder einen Teil der festgelegten direkten physikalischen Kommunikationsverbindungen betreffen. Die automatisiert erstellten direkten physikalischen Kommunikationsverbindungen können anstelle der manuell erstellten direkten physikalischen Kommunikationsverbindungen vorgesehen werden oder können auch redundante Verbindungen zusätzlich zu den manuell erstellten direkten physikalischen Kommunikationsverbindungen umfassen.

Beispielhafte Ausführungsformen der Erfindung umfassen weiterhin ein Verfahren zum Durchführen einer Simulation mit einem für die Steuergerätentwicklung eingerichteten, echtzeitfähigen Testgerät, wobei das Testgerät eine Vielzahl von Datenverarbeitungseinheiten aufweist und wobei mit der Vielzahl von Datenverarbeitungseinheiten eine Vielzahl von Simulationsmodellen assoziiert ist. Das Verfahren weist die folgenden Schritte auf: Festlegen der Kommunikationsanforderungen der Vielzahl von Simulationsmodellen; Bestimmen der physikalischen Verbindungstopologie des Testgeräts gemäß einem Verfahren nach einer der oben beschriebenen Ausführungsformen; Erstellen der festgelegten direkten physikalischen Kommunikationsverbindungen in dem Testgerät; und Durchführen der Simulation, wobei die Vielzahl von Simulationsmodellen während des Durchführens der Simulation untereinander Daten austauscht. Die zusätzlichen Merkmale, Modifikationen und technischen Effekte, die oben für das Verfahren zum Bestimmen einer physikalischen Verbindungstopologie beschrieben worden sind, sind analog auf das Verfahren zum Durchführen einer Simulation mit einem für die Steuergeräteentwicklung eingerichteten, echtzeitfähigen Testgerät anwendbar.

Weitere beispielhafte Ausführungsformen der Erfindung werden mit Bezug auf die beiliegenden Figuren beschrieben.
Fig. 1 zeigt einen HIL-Simulator als Testgerät, auf dem Verfahren gemäß beispielhaften Ausführungsformen der Erfindung ausführbar sind, zusammen mit einem daran angeschlossenen Steuergerät in einem Blockdiagramm;
Fig. 2 zeigt einen HIL-Simulator als Testgerät, bei dem die Datenverarbeitungseinheiten und Simulationsmodelle für die Simulation eines Motors und eines Getriebes eingerichtet sind, sowie die zwischen den Simulationsmodellen bestehenden logischen Kommunikationsverbindungen in einem Blockdiagramm;
Fig. 3 zeigt den HIL-Simulator der Fig. 2 und veranschaulicht die physikalische Verbindungstopologie, wie sie als Ergebnis eines Verfahrens gemäß einer beispielhaften Ausführungsform der Erfindung bestimmt worden sein kann;
Fig. 4 zeigt den HIL-Simulator der Fig. 2 und veranschaulicht die physikalische Verbindungstopologie, wie sie als Ergebnis eines Verfahrens gemäß einer weiteren beispielhaften Ausführungsform der Erfindung bestimmt worden sein kann.

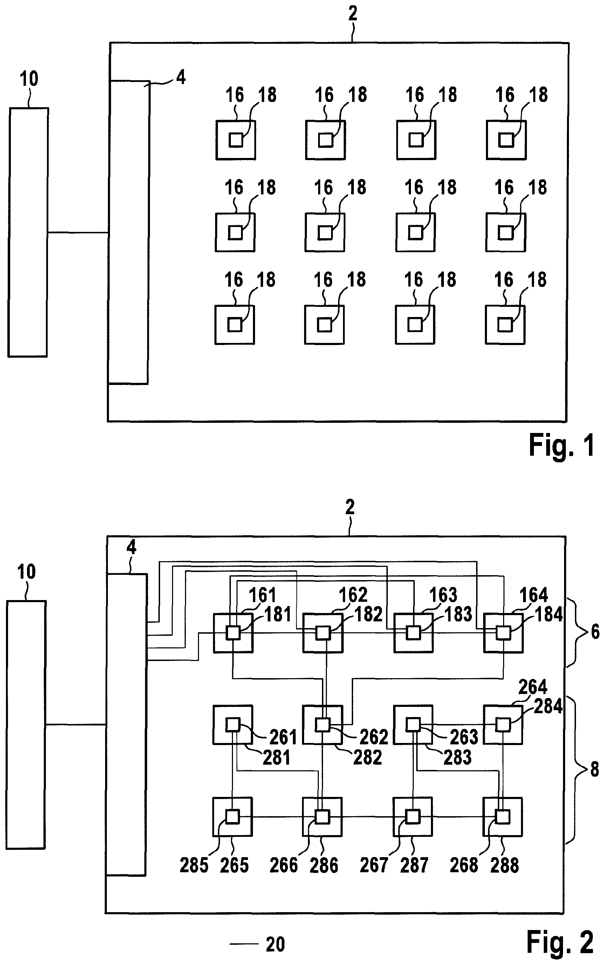

Fig. 1 zeigt ein echtzeitfähiges Testgerät 2, welches im vorliegenden Fall ein HIL-Simulator 2 ist. Der HIL-Simulator 2 hat eine physikalische externe Eingabe/Ausgabe-Schnittstelle 4, über die externen Geräte an den HIL-Simulator 2 anschließbar sind. In Fig. 1 ist ein Steuergerät 10 an die externe Eingabe/Ausgabe-Schnittstelle 4 angeschlossen. In dem Beispiel von Fig. 1 ist das Steugerät 10 ein Motorsteuergerät, das zum Steuern des Motors eines Kraftfahrzeugs eingerichtet ist. Der HIL-Simulator 2 ist zum Testen des Motorsteuergeräts 10 eingerichtet.

Der HIL-Simulator 2 beinhaltet eine Vielzahl von Datenverarbeitungseinheiten 16. In der beispielhaften Ausführungsform von Fig. 1 sind zwölf solcher Datenverarbeitungseinheiten 16 vorgesehen. In dem vorliegenden Beispiel enthält jede dieser Datenverarbeitungseinheiten 16 ein Simulationsmodell 18. Das Vorsehen genau eines Simulationsmodell 18 pro Datenverarbeitungseinheit 16 ist rein exemplarisch und dient der Veranschaulichung der Konfiguration der Kommunikation zwischen den Datenverarbeitungseinheiten 16, wie in Figuren 2 bis 4 veranschaulicht. Es ist möglich, dass mehr als ein Simulationsmodell 18 pro Datenverarbeitungseinheit 16 vorgesehen ist und dass unterschiedliche Anzahlen von Simulationsmodellen 18 auf den Datenverarbeitungseinheiten 16 vorgesehen sind. Es ist auch möglich, dass eine oder mehrere der Datenverarbeitungseinheiten 16 kein damit assoziiertes Simulationsmodell 18 haben. Im Betrieb werden die jeweiligen Simulationsmodelle 18 auf den jeweiligen Datenverarbeitungseinheiten 16 ausgeführt. Sie simulieren verschiedene technische Komponenten, mit denen das Steuergerät 10 während der Simulation direkt oder indirekt interagiert. Ein detailliertes Beispiel verschiedener technischer Komponenten, die durch die Simulationsmodelle 18 simuliert werden, wird im Folgenden mit Bezug auf Figuren 2 bis 4 beschrieben.

Fig. 2 zeigt ein Testgerät 2 in einer konkreten Ausgestaltung, bei der den Datenverarbeitungseinheiten und den damit assoziierten Simulationsmodellen konkrete technische Systeme bzw. Teilsysteme zugeordnet sind und bei dem eine exemplarische Kommunikation zwischen den Simulationsmodellen stattfindet. Das Testgerät 2 ist auch ein HIL-Simulator 2. Bei dem HIL-Simulator 2 der Fig. 2 kann es sich um den HIL-Simulator 2 der Fig. 1 handeln, bei dem durch das Aufspielen konkreter Simulationsmodelle eine konkreter Zusammenhang von Simulationen von technischen Komponenten hergestellt worden ist. Für die nicht diskutierten Komponenten der Fig. 2 wird auf die obige Beschreibung der Fig. 1 verwiesen.

In dem beispielhaften Testgerät 2 der Fig. 2 wird ein Motor und ein Getriebe simuliert. Der Motor ist in diesem Fall das von dem Steuergerät 10 zu steuernde technische System, während das Getriebe einen Teil der technischen Umgebung des Motors und des Steuergeräts 10 darstellt, dessen Interaktion mit dem Motor in dem Testgerät 2 auch modelliert wird. Für die Simulation des Motors werden in dem vorliegenden Beispiel vier Datenverarbeitungseinheiten verwendet. Diese sind eine erste Motor-Datenverarbeitungseinheit 161, eine zweite Motor-Datenverarbeitungseinheit 162, eine dritte Motor-Datenverarbeitungseinheit 163 und eine vierte Motor-Datenverarbeitungseinheit 164. Jede dieser Datenverarbeitungseinheiten 161, 162, 163, 164 ist mit einem zugehörigen Simulationsmodell assoziiert. Im vorliegenden Fall wird das Verhalten des Motors durch vier Motor-Teilsimulationsmodelle simuliert, nämlich durch ein erstes Motor-Teilsimulationsmodell 181, ein zweites Motor-Teilsimulationsmodell 182, ein drittes Motor-Teilsimulationsmodell 183 und ein viertes Motor-Teilsimulationsmodell 184. Die erste bis vierte Motor-Datenverarbeitungseinheit 161-164 und das erste bis vierte Motor-Teilsimulationsmodell 181-184 bilden zusammen das Motor-Modell 6 der Simulation.

Für die Simulation des Getriebes sind in dem exemplarischen Testgerät 2 der Fig. 2 eine erste Getriebe-Datenverarbeitungseinheit 261, eine zweite Getriebe-Datenverarbeitungseinheit 262, eine dritte Getriebe-Datenverarbeitungseinheit 263, eine vierte Getriebe-Datenverarbeitungseinheit 264, eine fünfte Getriebe-Datenverarbeitungseinheit 265, eine sechste Getriebe-Datenverarbeitungseinheit 266, eine siebte Getriebe-Datenverarbeitungseinheit 267 und eine achte Getriebe-Datenverarbeitungseinheit 268 vorgesehen. Mit diesen Datenverarbeitungseinheiten assoziiert sind ein erstes Getriebe-Teilsimulationsmodell 281, ein zweites Getriebe-Teilsimulationsmodell 282, ein drittes Getriebe-Teilsimulationsmodell 283, ein viertes Getriebe-Teilsimulationsmodell 284, ein fünftes Getriebe-Teilsimulationsmodell 285, ein sechstes Getriebe-Teilsimulationsmodell 286, ein siebtes Getriebe-Teilsimulationsmodell 287 und ein achtes Getriebe-Teilsimulationsmodell 288. Die erste bis achte Getriebe-Datenverarbeitungseinheit 261-268 und das erste bis achte Getriebe-Teilsimulationsmodell 281-288 bilden zusammen die Getriebe-Modell 8 der Simulation.

Während der Durchführung der Simulation interagiert das Steuergerät 10 mit dem Motor-Modell 6, welches wiederum mit dem Getriebe-Modell 8 interagiert. So kann das Verhalten und die Funktionalität des Steuergeräts 10 in Bezug auf das Motor-Modell 6 unter Bezugnahme auf die Umgebung des Getriebe-Modells 8 getestet werden. Die Kommunikation zwischen den einzelnen Entitäten wird im Folgenden beschrieben.

In Fig. 2 sind die logischen Kommunikationsverbindungen zwischen den einzelnen Entitäten in dünnen durchgezogenen Linien Linien 20 dargestellt. Das erste bis vierte Motor-Teilsimulationsmodell 181, 182, 183, 184 haben jeweils eine logische Kommunikationsverbindung zu der externen Eingabe/Ausgabe-Schnittstelle 4 und somit zu dem Steuergerät 10. Weiterhin hat das erste Motor-Teilsimulationsmodell 181 jeweils eine logische Kommunikationsverbindung zu jedem des zweiten bis vierten Motor-Teilsimulationsmodells 182, 183, 184. Weiterhin bestehen sowohl zwischen dem zweiten Motor-Teilsimulationsmodell 182 und dem dritten Motor-Teilsimulationsmodell 183 als auch zwischen dem dritten Motor-Teilsimulationsmodell 183 und dem vierten Motor-Teilsimulationsmodell 184 logische Kommunikationsverbindungen. Darüber hinaus sind logische Kommunikationsverbindungen gegeben zwischen jedem von dem ersten Motor-Teilsimulationsmodell 181, dem zweiten Motor-Teilsimulationsmodell 182 und dem vierten Motor-Teilsimulationsmodell 184 auf der einen Seite und dem zweiten Getriebe-Teilsimulationsmodell 282. Das zweite Getriebe-Teilsimulationsmodell 282 stellt somit die Schnittstelle zwischen dem Motor-Modell 6 und dem Getriebe-Modell 8 dar. Unter den Getriebe-Teilsimulationsmodellen 261-268 gibt es eine Vielzahl von logischen Kommunikationsverbindungen, wie aus Fig. 2 ersichtlich ist.

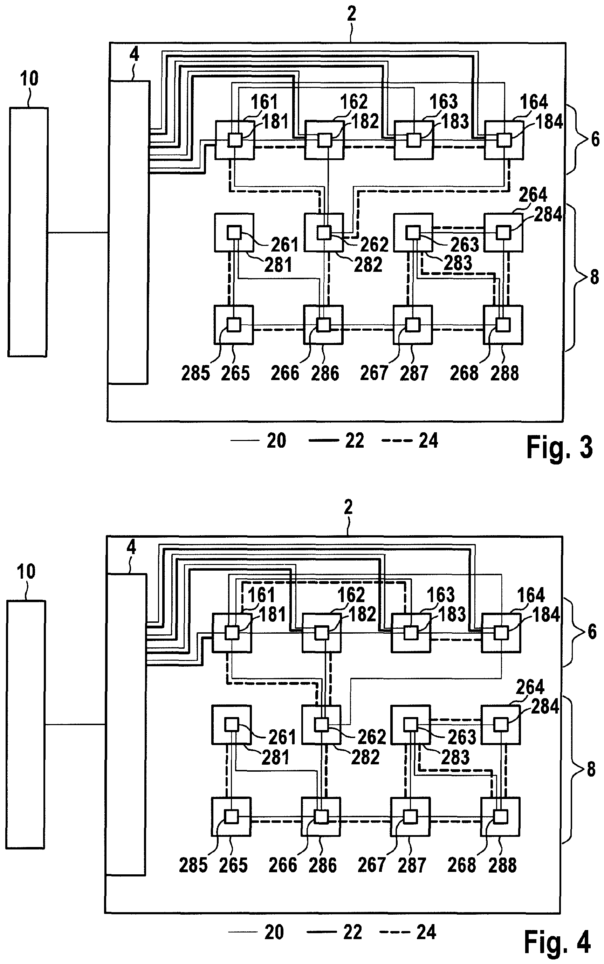

Die logischen Kommunikationsverbindungen 20 stellen den Datenaustausch zwischen den einzelnen Teilsimulationsmodellen in seiner Gesamtheit dar. Jede logische Kommunikationsverbindung entspricht einer Verbindung von zwei Teilsimulationsmodellen, die während der Simulation Daten austauschen, wobei der Datenaustausch unidirektional oder bidirektional sein kann. Für die gegebenen logischen Kommunikationsverbindungen 20 wird zur Durchführung der Simulation eine physikalische Verbindungstopologie zwischen den Datenverarbeitungseinheiten erstellt, über welche der Datenaustausch physikalisch abgewickelt werden kann. Beispielhafte Festlegungen der physikalischen Verbindungen werden im Folgenden mit Bezug auf Fig. 3 und Fig. 4 beschrieben.

Fig. 3 zeigt den HIL-Simulator 2 und das Steuergerät 10 der Fig. 2. Wiederum sind die logischen Kommunikationsverbindungen 20 mit dünnen durchgezogenen Linien dargestellt. Darüber hinaus sind in Fig. 3 die physikalischen Kommunikationsverbindungen zwischen den Entitäten des HIL-Simulators 2 dargestellt. Dabei sind einerseits die physikalischen Verbindungen zwischen den einzelnen Datenverarbeitungseinheiten und der externen Eingabe-/Ausgabeschnittstelle 4 mit fetten durchgezogenen Linien 22 dargestellt und andererseits die direkten physikalischen Kommunikationsverbindungen zwischen den Datenverarbeitungseinheiten mit fetten gestrichelten Linien 24 dargestellt. Das Bestimmen der physikalischen Verbindungstopologie auf Grundlage der logischen Kommunikationsverbindungen 20 wird im Folgenden dargelegt.

Das Verfahren zum Bestimmen der physikalischen Verbindungstopologie geht von den folgenden Rahmenbedingungen aus. In der beispielhaften Ausführungsform der Fig. 3 hat jede der Datenverarbeitungseinheiten 161-164 und 261-268 drei physikalische Schnittstellen. In anderen Worten, drei physikalische Datenleitungen können von jeder der Datenverarbeitungseinheiten abgehen bzw. dort ankommen. Weiterhin wird festgelegt, dass für jede logische Kommunikationsverbindung zwischen einem Teilsimulationsmodell und der externen Eingabe/Ausgabe-Schnittstelle 4 eine entsprechende physikalische Verbindung zwischen der zugehörigen Datenverarbeitungseinheit und der externen Eingabe/Ausgabe-Schnittstelle vorgesehen sein soll. Somit wird für jede der ersten bis vierten Motor-Datenverarbeitungseinheit 161, 162, 163, 164 eine physikalische Kommunikationsverbindung zu der externen Eingabe/Ausgabe-Schnittstelle 4 vorgesehen, hier dargestellt durch fette durchgezogene Linien 22. Diese vier physikalischen Kommunikationsverbindungen bilden das Eingabe/Ausgabe-Verbindungsnetzwerk des HIL-Simulators 2. Somit stehen für jede der ersten bis vierten Motor-Datenverarbeitungseinheit 161-164 lediglich zwei physikalische Schnittstellen für die Kommunikation zwischen den Datenverarbeitungseinheiten zur Verfügung. In anderen Worten, die festgelegte Menge an physikalischen Schnittstellen für die erste bis vierte Motor-Datenverarbeitungseinheit 161-164 ist zwei. Für die erste bis achte Getriebe-Datenverarbeitungseinheit 261-268 ist die festgelegte Menge an physikalischen Schnittstellen drei.

Basierend auf den festgelegten Mengen von zur Verfügung stehenden physikalischen Schnittstellen werden die direkten physikalischen Kommunikationsverbindungen festgelegt. In der beispielhaften Ausführungsform der Fig. 3 werden die direkten physikalischen Kommunikationsverbindungen mit dem Optimierungsziel festgelegt, dass für eine möglichst geringe Anzahl von logischen Kommunikationsverbindungen eine indirekte physikalische Kommunikationsverbindung, d.h. eine physikalische Kommunikationsverbindung durch eine nicht an der logischen Kommunikationsverbindung beteiligte Datenverarbeitungseinheit, vorgesehen ist. In anderen Worten, das Verfahren gemäß einer beispielhaften Ausführungsform der Erfindung versucht, für möglichst viele der logischen Kommunikationsverbindungen 20 direkte physikalische Kommunikationsverbindungen zu erstellen.

Das Ergebnis dieser Optimierung ist in Fig. 3 durch die fetten gestrichelten Linien 24 dargestellt, welche die direkten physikalischen Kommunikationsverbindungen 24 zwischen den Datenverarbeitungseinheiten darstellen. In dem vorliegenden Beispiel gibt es für 14 logische Kommunikationsverbindungen zwischen jeweils zwei Datenverarbeitungseinheiten eine direkte physikalische Kommunikationsverbindung 24. Lediglich für vier logische Kommunikationsverbindungen gibt es keine direkte physikalische Kommunikationsverbindung. Die entsprechenden Daten müssen dann durch eine zwischengeschaltete Datenverarbeitungseinheit geroutet werden. Die Daten zwischen der ersten Motor-Datenverarbeitungseinheit 161 und der dritten Motor-Datenverarbeitungseinheit 163 können z.B. durch die zweite Motor-Datenverarbeitungseinheit 162 weitergereicht werden. Die Daten zwischen der ersten Motor-Datenverarbeitungseinheit 161 und der vierten Motor-Datenverarbeitungseinheit 164 können z.B. durch die zweite Getriebe-Datenverarbeitungseinheit 262 weitergereicht werden. Die Daten zwischen der zweiten Motor-Datenverarbeitungseinheit 162 und der zweiten Getriebe-Datenverarbeitungseinheit 262 können z.B. durch die erste Motor-Datenverarbeitungseinheit 161 weitergereicht werden. Und die Daten zwischen der ersten Getriebe-Datenverarbeitungseinheit 262 und der sechsten Getriebe-Datenverarbeitungseinheit 266 können durch die fünfte Getriebe-Datenverarbeitungseinheit 265 weitergereicht werden.

Für alle logischen Kommunikationsverbindungen gibt es somit zumindest eine indirekte physikalische Kommunikationsverbindung. Außerdem sind, wie gemäß Rahmenbedingungen erforderlich, an jeder Datenverarbeitungseinheit höchstens drei physikalische Schnittstellen belegt. Die Summe aller Hops über alle indirekten physikalischen Kommunikationsverbindungen ist vier und ist somit auch minimal bei der in Fig. 3 gezeigten physikalischen Verbindungstopologie. Somit ist die physikalische Verbindungstopologie der Fig. 3 auch ein Ergebnis, zu dem das Verfahren im Rahmen einer Minimierung der Hops der indirekten physikalischen Kommunikationsverbindungen gelangen hätte können.

Fig. 4 zeigt das Ergebnis einer anders gelagerten Optimierung für den gleichen Fall des HIL-Simulators 2 der Fig. 2 mit den darin gezeigten logischen Kommunikationsverbindungen 20. Gemäß dem Verfahren der beispielhaften Ausführungsform der Erfindung der Fig. 4 berücksichtigt die Optimierungsfunktion neben der Anzahl der Hops die Latenz beim Weiterreichen der Daten in einer zwischengeschalteten Datenverarbeitungseinheit und die Datenrate einer logischen Kommunikationsverbindung. Beispielsweise könnte die Optimierungsfunktion die Summe des Produkts von Hops, Latenz pro Hop und Datenrate über alle logischen Kommunikationsverbindungen, die nicht durch direkte physikalische Kommunikationsverbindungen implementiert werden, minimieren.

Weiterhin beruht das Bestimmen der physikalischen Verbindungstopologie der Ausführungsform der Fig. 4 auf der Annahme, dass die logische Kommunikationsverbindung zwischen dem ersten Motor-Teilsimulationsmodell 181 und dem dritten Motor-Teilsimulationsmodell 183 sowie die logische Kommunikationsverbindung zwischen dem zweiten Motor-Teilsimulationsmodell 182 und dem zweiten Getriebe-Teilsimulationsmodell 282 so hohe Datenraten haben, dass indirekte physikalische Verbindungen, d.h. physikalische Verbindungen mit mehr als 0 Hops, einen so großen Einfluss auf die oben genannte Optimierungsfunktion haben, dass nur direkte physikalische Verbindungen für diese zwei logischen Kommunikationsverbindungen zu einem gemäß Optimierungsfunktion optimalen Ergebnis kommen können. Beim Vergleich von Fig. 4 zu Fig. 3 ist ersichtlich, dass jetzt direkte physikalische Kommunikationsverbindungen 24 zwischen der ersten Motor-Datenverarbeitungseinheit 161 und der dritten Motor-Datenverarbeitungseinheit 163 sowie zwischen der zweiten Motor-Datenverarbeitungseinheit 162 und der zweiten Getriebe-Datenverarbeitungseinheit 262 vorhanden sind.

Da für jede Datenverarbeitungseinheit die festgelegte Menge der physikalischen Schnittstellen, wie oben ausgeführt, nicht überschritten werden darf, müssen andere direkte physikalische Kommunikationsverbindungen eliminiert werden. Insgesamt gibt es gemäß der Ausführungsform der Fig. 4 nun fünf logische Kommunikationsverbindungen, für die es keine direkten Kommunikationsverbindungen gibt.

Auch gibt es für die logische Kommunikationsverbindung zwischen dem zweiten Motor-Teilsimulationsmodell 182 und dem dritten Motor-Teilsimulationsmodell 183 nur eine indirekte physikalische Kommunikationsverbindung mit zwei Hops, nämlich über die zweite Getriebe-Datenverarbeitungseinheit 262 und die erste Motor-Datenverarbeitungseinheit 161.

Somit ist Fig. 4 ein exemplarisches Beispiel, das verdeutlicht, dass eine Optimierungsfunktion auch zu Ergebnissen führen kann, die nicht die Anzahl der indirekten physikalischen Kommunikationsverbindungen oder die Anzahl der Hops der indirekten physikalischen Kommunikationsverbindungen minimiert, aber trotzdem im Lichte weiterer Parameter, wie z.B. der Latenz in den Hops und der Datenrate der logischen Kommunikationsverbindungen, eine optimierte physikalische Verbindungstopologie ergibt.

Nachdem eine solche physikalische Verbindungstopologie automatisiert bestimmt worden ist, können das Eingabe/Ausgabe-Verbindungsnetzwerk 22 und die direkten physikalischen Kommunikationsverbindungen 24 manuell gesteckt werden oder automatisiert durch Schalten entsprechender Anschlüsse von entsprechenden Leitungen an den Datenverarbeitungseinheiten bzw. der Eingabe/Ausgabe-Schnittstelle 4 erstellt werden.

Der Verfahren zum Bestimmen der physikalischen Verbindungstopologie kann auf dem HIL-Simulator 2 ausgeführt werden. Es ist auch möglich, dass das Verfahren in einem externen Gerät, wie z.B. einem externen Computer, ausgeführt wird, der für die Konfiguration der Simulation mit dem HIL-Simulator verbunden ist.

Es wird nochmals betont, dass die Beispiele der Figuren rein beispielhaft sind und zur Illustration des Verfahrens gemäß beispielhafter Ausführungsformen der Erfindung dienen sollen. Insbesondere sind die Anzahl der Datenverarbeitungseinheiten, der Simulationsmodelle, der physikalischen Schnittstellen pro Datenverarbeitungseinheit sowie die Art und Anzahl der logischen Kommunikationsverbindungen rein beispielhaft. Auch sind die für die Optimierungsfunktion zugrunde gelegten Parameter rein beispielhaft. Es können alle hierin genannten Parameter in jeder Kombination berücksichtigt werden.

Obwohl die Erfindung mit Bezug auf beispielhafte Ausführungsformen beschrieben worden ist, ist es für einen Fachmann ersichtlich, dass verschiedene Änderungen vorgenommen und Äquivalente verwendet werden können, ohne den Bereich der Erfindung zu verlassen. Die Erfindung soll nicht durch die beschriebenen spezifischen Ausführungsformen beschränkt sein. Vielmehr enthält sie alle Ausführungsformen, die unter die angehängten Patentansprüche fallen.

## Patentansprüche

1. Verfahren zum Bestimmen einer physikalischen Verbindungstopologie eines für die Steuergerätentwicklung eingerichteten, echtzeitfähigen Testgeräts (2),
wobei das Testgerät (2) eine Vielzahl von Datenverarbeitungseinheiten (16) aufweist, wobei jede Datenverarbeitungseinheit (16) eine festgelegte Menge an physikalischen Schnittstellen für die Kommunikation zwischen den Datenverarbeitungseinheiten (16) hat, und
wobei mit der Vielzahl von Datenverarbeitungseinheiten eine Vielzahl von Simulationsmodellen (18) assoziiert ist, wobei die Vielzahl von Simulationsmodellen (18) mindestens ein Modell eines zu steuernden technischen Systems und/oder mindestens ein Modell einer Steuerung eines technischen Systems und/oder mindestens ein technisches Umgebungsmodell umfasst,
wobei das Verfahren die folgenden Schritte aufweist:
Bestimmen der logischen Kommunikationsverbindungen (20) zwischen den Simulationsmodellen, wobei jede logische Kommunikationsverbindung eine Datenverbindung zwischen zwei der Vielzahl von Simulationsmodellen repräsentiert und wobei die festgelegte Menge an physikalischen Schnittstellen für mindestens eine der Vielzahl von Datenverarbeitungseinheiten kleiner als die Menge der mit derjenigen Datenverarbeitungseinheit assoziierten logischen Kommunikationsverbindungen ist, und
automatisiertes Bestimmen der physikalischen Verbindungstopologie durch Festlegen von direkten physikalischen Kommunikationsverbindungen (24) zwischen den Datenverarbeitungseinheiten unter Berücksichtigung der jeweiligen Mengen an physikalischen Schnittstellen, wobei das Festlegen der direkten physikalischen Kommunikationsverbindungen (24) für jede der logischen Kommunikationsverbindungen (20) festlegt, ob eine der logischen Kommunikationsverbindung (20) entsprechende direkte physikalische Kommunikationsverbindung (24) Teil der physikalischen Verbindungstopologie ist.

2. Verfahren nach Anspruch 1, wobei das Festlegen der direkten physikalischen Kommunikationsverbindungen (24) auf Basis einer Optimierungsfunktion durchgeführt wird.

3. Verfahren nach Anspruch 2, wobei die Optimierungsfunktion die Anzahl derjenigen logischen Kommunikationsverbindungen berücksichtigt, für die keine direkte physikalische Kommunikationsverbindung Teil der physikalischen Verbindungstopologie ist.

4. Verfahren nach Anspruch 2 oder 3, wobei die Optimierungsfunktion die Anzahl der durchlaufenen Datenverarbeitungseinheiten für diejenigen logischen Kommunikationsverbindungen berücksichtigt, für die keine direkte physikalische Kommunikationsverbindung Teil der physikalischen Verbindungstopologie ist.

5. Verfahren nach einem der Ansprüche 2 bis 4, wobei die Optimierungsfunktion mindestens eine Hardware-Eigenschaft von mindestens einem von den Datenverarbeitungseinheiten (16), den physikalischen Schnittstellen der Datenverarbeitungseinheiten und den physikalischen Kommunikationsverbindungen (24) berücksichtigt.

6. Verfahren nach Anspruch 5, wobei die mindestens eine Hardware-Eigenschaft mindestens eine Eigenschaft von Latenz, maximalem Datendurchsatz und Kollisionshandhabung umfasst.

7. Verfahren nach einem der Ansprüche 2 bis 6, wobei die Optimierungsfunktion mindestens eine Kommunikationseigenschaft der logischen Kommunikationsverbindungen (20) berücksichtigt.

8. Verfahren nach Anspruch 7, wobei die mindestens eine Kommunikationseigenschaft mindestens eines von Datenübertragungsrichtung, Taktrate von zu übertragenen Daten, Datenmenge und Datenbedarf asynchroner Ereignisse umfasst.

9. Verfahren nach einem der Ansprüche 5 bis 8, wobei mittels der Optimierungsfunktion diejenige physikalische Verbindungstopologie bestimmt wird, die einen möglichst schnellen und/oder stabilen Datenaustausch der Simulationsmodelle über die Gesamtheit der logischen Kommunikationsverbindungen erlaubt.

10. Verfahren nach einem der vorhergehenden Ansprüche, wobei das Testgerät (2) mindestens eine externe Eingabe/Ausgabe-Schnittstelle (4) aufweist und wobei zwischen der Vielzahl von Datenverarbeitungseinheiten (16) und der mindestens einen externen Eingabe/Ausgabe-Schnittstelle (4) ein Eingabe/Ausgabe-Verbindungsnetzwerk (22) vorhanden ist, wobei für jede Datenverarbeitungseinheit die festgelegte Menge an physikalischen Schnittstellen auf Basis der Gesamtanzahl von physikalischen Schnittstellen der jeweiligen Datenverarbeitungseinheit und des Eingabe/Ausgabe-Verbindungsnetzwerks (22) bestimmt wird.

11. Verfahren nach einem der vorhergehenden Ansprüche, wobei das Testgerät (2) ein Hardware-in-the-Loop-Simulator oder ein Rapid-Control-Prototype ist.

12. Verfahren nach einem der vorhergehenden Ansprüche, weiterhin aufweisend den folgenden Schritt:
Beurteilen der Echtzeitfähigkeit des Testgeräts (2) für die bestimmte physikalische Verbindungstopologie.

13. Verfahren nach einem der vorhergehenden Ansprüche, weiterhin aufweisend den folgenden Schritt:
Ausgeben der physikalischen Verbindungstopologie an einen Benutzer, insbesondere graphisches Ausgeben der physikalischen Verbindungstopologie an einen Benutzer, zur manuellen Erstellung der direkten physikalischen Kommunikationsverbindungen.

14. Verfahren nach einem der vorhergehenden Ansprüche, weiterhin aufweisend den folgenden Schritt:
automatisiertes Erstellen von festgelegten direkten physikalischen Kommunikationsverbindungen, insbesondere automatisiertes Erstellen von festgelegten direkten physikalischen Kommunikationsverbindungen mittels Schalten von optischen Schaltern.

15. Verfahren zum Durchführen einer Simulation mit einem für die Steuergerätentwicklung eingerichteten, echtzeitfähigen Testgerät (2), wobei das Testgerät (2) eine Vielzahl von Datenverarbeitungseinheiten (16) aufweist und wobei mit der Vielzahl von Datenverarbeitungseinheiten (16) eine Vielzahl von Simulationsmodellen (18) assoziiert ist, aufweisend die folgenden Schritte:
Festlegen der Kommunikationsanforderungen der Vielzahl von Simulationsmodellen (18),
Bestimmen der physikalischen Verbindungstopologie des Testgeräts gemäß einem Verfahren nach einem der Ansprüche 1 bis 12,
Erstellen der festgelegten direkten physikalischen Kommunikationsverbindungen (24) in dem Testgerät, und
Durchführen der Simulation, wobei die Vielzahl von Simulationsmodellen während des Durchführens der Simulation untereinander Daten austauscht.
